Europäisches Patentamt

European Patent Office

Office européen des brevets

(11) Veröffentlichungsnummer: **0 212 128**
A2

(12) # EUROPÄISCHE PATENTANMELDUNG

(21) Anmeldenummer: **86108368.1**

(51) Int. Cl.⁴: **H 03 M 1/22**

(22) Anmeldetag: **19.06.86**

(30) Priorität: **23.08.85 DE 3530182**

(71) Anmelder: **ROBERT BOSCH GMBH, Postfach 50, D-7000 Stuttgart 1 (DE)**

(43) Veröffentlichungstag der Anmeldung: **04.03.87 Patentblatt 87/10**

(72) Erfinder: **Köpke, Wolfgang, Dipl.-Ing., Prinzregentenstrasse 7, D-1000 Berlin 31 (DE)**

(74) Vertreter: **Schmidt, Hans-Ekhardt, Robert Bosch GmbH Geschäftsbereich Elektronik Patent- und Lizenzabteilung Forckenbeckstrasse 9-13, D-1000 Berlin 33 (DE)**

(84) Benannte Vertragsstaaten: **CH DE GB IT LI**

(54) Fotoelektrische Einstellvorrichtung.

(57) Es wird eine fotoelektrische Einstellvorrichtung vorge-schlagen, die für ein Meßgerät, vorzugsweise für ein Audio-meter, bestimmt ist. Die Einstellvorrichtung weist einen Kodierungsträger (13) auf, der von Hand schrittweise ge-genüber einer feststehend angeordneten fotoelektrischen Abtastvorrichtung (17) bewegbar ist. Der Kodierungsträger trägt auf seiner Unterseite reflektierende Marken (14) und nichtreflektierende Marken (15), die durch einen Lichtsen-der (22) und einen Lichtempfänger (23) der Abtastvorrich-tung abtastbar sind. Die digitalen Informationen sind in Gruppen aufgeteilt, und je Gruppe ist eine von mehreren parallelen Spuren auf dem Kodierungsträger vorgesehen. Die digitalen Informationen sind dabei derart kodiert, daß bei einer schrittweisen Bewegung des Kodierungsträgers je Schritt nur in einer Spur der Digitalwert geändert wird.

39/85
EK/PLI Scht-Li
22.8.1985


ROBERT BOSCH GMBH, 7000 Stuttgart 1


Fotoelektrische Einstellvorrichtung


Stand der Technik

Die Erfindung geht von einer fotoelektrischen Einstellvorrichtung nach der Gattung des Anspruchs 1 aus.

Es ist eine fotoelektrische Einstellvorrichtung bekannt (DE-OS 30 11 651), bei der ein Einsteller mit einer Blende versehen ist, die Durchbrüche entsprechend einer vorgegebenen Kodierung aufweist. Die Blende ist zwischen fest angeordneten Leuchtdioden und Fototransistoren mittels des Einstellers verschiebbar. Die bekannte Vorrichtung hat den Nachteil, daß nach dem Einschalten des Meßgerätes die Blende grundsätzlich von einer bekannten Ausgangsstellung aus verschoben werden muß, um überhaupt ein Kodewort erkennen zu können. Es ist weiterhin bekannt (DE-OS 33 39 209), auf einem bandförmigen Träger in Form von reflektierenden Marken angebrachte Kodierungen mittels einer Abtastvorrichtung aus Lichtsender und Lichtempfänger abzutasten.

Vorteile der Erfindung

Die erfindungsgemäße fotoelektrische Einstellvorrichtung mit den kennzeichnenden Merkmalen des Anspruchs 1 hat den Vorteil, daß zu jedem Zeitpunkt, also auch in der Ruhestellung des Kodierungsträgers, unmittelbar nach dem Einschalten des Meßgerätes die der jeweiligen Einstellung entsprechende Kodierung verfügbar ist. Ein weiterer Vorteil besteht darin, daß Fehlsteuerungen vermieden werden, die bei nicht genau rechtwinkliger Abtaststellung der Abtastvorrichtung gegenüber dem Kodierungsträger auftreten könnten.

...

## Zeichnung

Ein Ausführungsbeispiel der Erfindung ist in der Zeichnung anhand mehrerer Figuren dargestellt und in der nachfolgenden Beschreibung näher erläutert. Die Zeichnung zeigt in

Fig. 1    eine Schnittansicht in Längsrichtung einer erfindungsgemäßen Einstellvorrichtung,

Fig. 2    eine Schnittansicht gemäß dem Schnittverlauf II - II

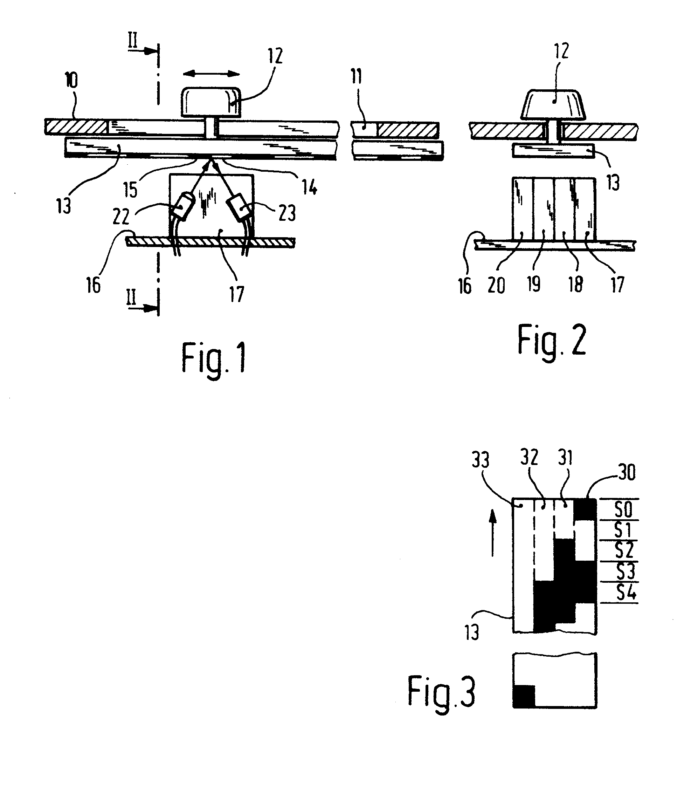

          in Fig. 1 und

Fig. 3    einen mit erfindungsgemäßen Kodierungen versehenen
          Kodierungsträger.

## Beschreibung der Erfindung

Eine erfindungsgemäße fotoelektrische Einstellvorrichtung nach den Fig. 1 und 2 weist eine Deckplatte 10 mit einem Längsschlitz 11 auf, in welchem ein von Hand betätigbares Einstellelement 12 in Richtung des in Fig. 1 gezeigten Doppelpfeils schrittweise verschiebbar angeordnet ist. Das Einstellelement ist an seiner Unterseite mit einem Kodierungsträger 13 fest verbunden, der auf seiner Unterseite reflektierende Marken 14 und nichtreflektierende oder weniger reflektierende Marken 15 in einer bestimmten, weiter unten erläuterten Anordnung trägt. Unterhalb des Kodierungsträgers 13 sind auf einer feststehenden Platine 16 nebeneinander vier fotoelektrische Abtastvorrichtungen 17, 18, 19 und 20 befestigt. Die Abtastvorrichtungen enthalten je einen Lichtsender 22 und einen Lichtempfänger 23. Der Lichtsender ist beispielsweise eine Leuchtdiode und der Lichtempfänger ein Fotowiderstand. Lichtsender und Lichtempfänger sind innerhalb der Abtastvorrichtungen derart zueinander ausgerichtet, daß ein von dem Lichtsender 22 ausgehender und von einer reflektierenden Marke, zum Beispiel 15, reflektierter Lichtstrahl auf den Lichtempfänger 23 fällt.

Nach Fig. 3 sind die Kodierungen auf dem Kodierungsträger 13 in vier parallelen Spuren 30, 31, 32 und 33 untergebracht.

                                                                        ...

Die vorstehend beschriebene Einstellvorrichtung funktioniert folgendermaßen. Befindet sich das Einstellelement 12 in der in Fig. 1 gezeigten Lage, so gelangt der von dem Lichtsender 22 ausgehende Lichtstrahl von der nichtreflektierenden Marke 14 auf die reflektierende Marke 15; damit fällt auf den Lichtempfänger 23 bzw. den Fotowiderstand ein reflektierter Lichtstrahl, wodurch der durch den Fotowiderstand fließende Strom ansteigt. Dieser Stromanstieg entspricht einem Übergang von dem logischen Wert 0 zu dem logischen Wert 1. Mit dem sich bei einer Verschiebung des Kodierungsträgers 13 um einen Schritt aus den parallelen Spuren 30 ... 33 ergebenden Kodewort wird zum Beispiel der Oszillator eines Audiometers von einer Frequenz $f_1$ auf eine Frequenz $f_2$ umgeschaltet.

Die Kodierung auf dem Kodierungsträger 13 ist nun so gewählt, daß sich bei jedem Schritt S0, S1, ... des Kodierungsträgers 13 nur in einer der Spuren 30 ... 33 der logische Wert ändert. Dieser Sachverhalt sei anhand der Fig. 3 näher erläutert. Wird zum Beispiel der Kodierungsträger 13 um einen Schritt, zum Beispiel von S0 nach S1, bewegt, so findet nur in der Spur 30 eine Änderung des logischen Wertes statt, nämlich von dem logischen Wert 0 (nichtreflektierende Marke) zu dem logischen Wert 1 (reflektierende Marke). Bei dem nächsten Schritt, das heißt bei dem Übergang von dem Schritt S1 zu dem Schritt S2, findet nur in der Spur 31 eine Änderung des logischen Wertes statt, nämlich von dem Wert logisch 1 zu dem Wert logisch 0 usw. Die logischen Werte bzw. die schrittweise erhaltenen Kodierungen werden mittels dem Fachmann bekannter elektronischer Vorrichtungen ausgewertet. Der Kodierungsträger 13 kann, wie in dem Ausführungsbeispiel gezeigt, ein starrer Träger sein; es kann jedoch auch vorteilhaft sein, einen bandförmigen Träger zu verwenden, insbesondere dann, wenn sehr viele Kodierschritte vorgesehen sind.

In dem Ausführungsbeispiel nach den Fig. 1 und 2 wird davon ausgegangen, daß der Kodierungsträger 13 schrittweise bewegt wird. Es ist jedoch auch möglich, in dem Meßgerät den Kodierungsträger feststehend anzuordnen und die fotoelektrische Abtastvorrichtung schrittweise zu bewegen.

Für die Kodierung eignet sich vorzugsweise der unter der Bezeichnung Gray-Kode bekannte Kode.

39/85
EK/PLI Scht-Li
22.8.1985

0212128

ROBERT BOSCH GMBH, 7000 Stuttgart 1

## Ansprüche

1. Fotoelektrische Einstellvorrichtung für ein Meßgerät, vorzugsweise für ein Audiometer, mit einem Kodierungsträger, auf dem digitale Informationen durch reflektierende und nichtreflektierende Marken gespeichert und mittels einer Lichtsender und Lichtempfänger enthaltenden fotoelektrischen Abtastvorrichtung abtastbar sind, dadurch gekennzeichnet, daß die digitalen Informationen in Gruppen aufgeteilt und diese in parallel liegenden Spuren (30) auf dem Kodierungsträger (13) angeordnet sind und daß bei schrittweiser Bewegung des Kodierungsträges oder der Abtastvorrichtung (17) je Schritt (S0, S1) nur in einer Spur eine Änderung des Digitalwertes stattfindet.

2. Fotoelektrische Einstellvorrichtung nach Anspruch 1, dadurch gekennzeichnet, daß die Marken (14, 15) auf der Unterseite des Kodierungsträgers (13) angeordnet sind und daß die fotoelektrische Abtastvorrichtung (17) unterhalb des Kodierungsträgers feststehend angeordnet ist.

Fig.1

Fig.2

Fig.3